# EUROPÄISCHE PATENTSCHRIFT

(11) **EP 0 535 458 B1**
(45) Veröffentlichungstag und Bekanntmachung des Hinweises auf die Patenterteilung: **01.05.1996**
(21) Anmeldenummer: 92115916.6
(22) Anmeldetag: 17.09.1992
(51) Int. Cl.: C08F 2/50, G03F 7/031

(54) **Fotochemisch reaktive Initiatoren für die radikalische Polymerisation**
Photochemically reactive initiators for the radical polymerization
Initiateurs photochimiquement réactifs pour la polymérisation radicalaire

(30) Priorität: 30.09.1991 DE 4132467
(43) Veröffentlichungstag der Anmeldung: 07.04.1993
(73) Patentinhaber: BAYER AG, D-51368 Leverkusen (DE)
(72) Erfinder: Heiliger, Ludger, Dr., W-5090 Leverkusen 1 (DE)

(56) Entgegenhaltungen:
- EP-A- 0 187 332
- EP-A- 0 328 036
- EP-A- 0 341 720
- US-A- 3 956 269
- US-A- 4 048 034

## Beschreibung

Aus EP-A 341 720 sind Verbindungen bekannt, die lichtempfindliche radikalerzeugende Teile enthalten und bei Bestrahlung mit Licht Radikale erzeugen.

Es wurden fotochemisch reaktive Initiatoren gefunden, die den allgemeinen Aufbau der Formel (I) aufweisen 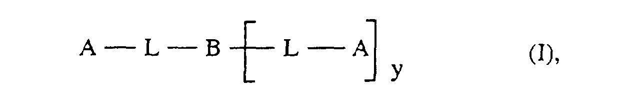 worin
- A: ausgewählt ist aus der Gruppe der Acridine, Furocumarine, Phenanthridine, Phenazine, Phenothiazine, Chinoline, Antracycline. Netropsin, Distamycin oder bis-Benzimidazole,
- B: ausgewählt ist aus folgenden Strukturen

1) Azostrukturen der allgemeinen Formel (V)

   R¹¹ - N = N - R¹ (V),

   worin
   - R¹¹ und R¹: C₁-C₂₀-Alkyl, C₃-C₁₀₋Cycloalkyl, C₇-C₂₀-Aralkyl oder die Gruppe 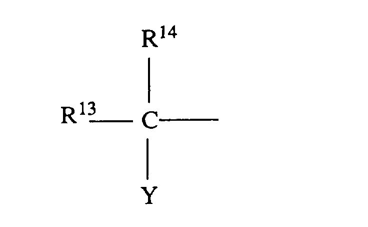 bedeuten, und
   - Y: CN, N₃ oder 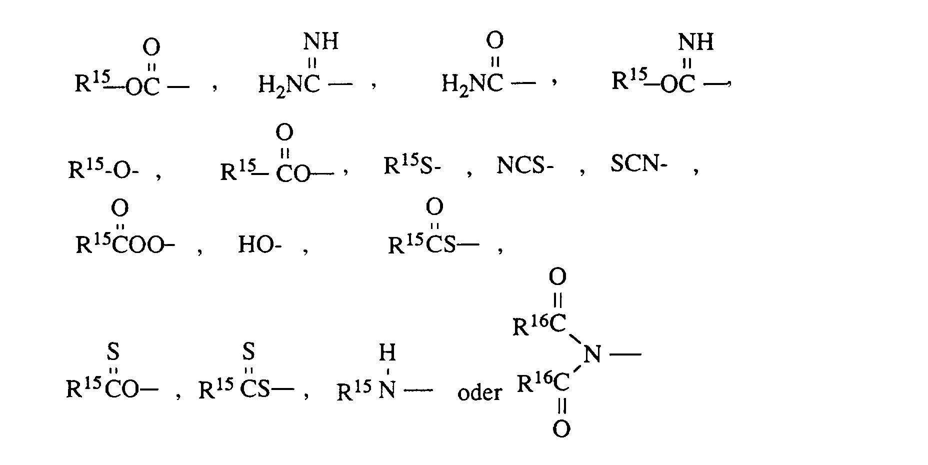 bedeutet,
   - R¹³, R¹⁴ und R¹⁵: unabhängig voneinander C₁-C₂₀-Alkyl, C₃-C₆-Cycloalkyl bedeuten oder wenn R¹³ und R¹⁴ verknüpft sind C₂-C₃₀-Alkylen bedeuten oder zusätzlich einer der Reste R¹³ oder R¹⁴, jedoch nicht beide gleichzeitig, Phenyl, Tolyl, Xylyl, Benzyl oder Phenethyl bedeutet,
   - R¹⁶: unabhängig C₁-C₆-Alkyl, C₃-C₆-Cycloalkyl oder C₆-C₁₂-Aryl bedeutet;
2) Tetraaryl/alkylethane der allgemeinen Formel (VI) 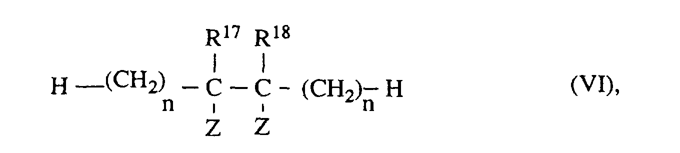 in welcher
   - Z: für Hydroxy, C₁-C₆-Alkyl oder C₆-C₂₀-Aryl, insbesondere für Hydroxy, Methyl, Ethyl, n- oder iso-Propyl, Phenyl oder Naphthyl steht,
   - R¹⁷ und R¹⁸: unabhängig voneinander für C₁-C₆-Alkyl oder C₆-C₂₀-Aryl, insbesondere für Methyl, Ethyl, n- oder iso-Propyl, Phenyl oder Naphthyl stehen und
   - n: für die Zahlen 1 bis 6, vorzugsweise 1, 2, 3, 4 oder 5, steht;
3) Dinitrile der Formel (VII) 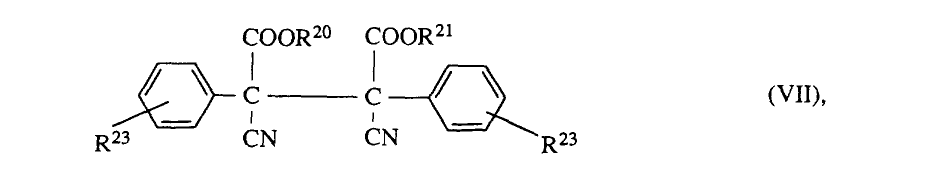 in welcher
   R⁰, R¹ und R³ unabhängig voneinander für (CH₂)̵ₘH stehen,
   worin
   - m: für die Zahlen 1 bis 6, vorzugsweise 1, 2, 3, 4 oder 5 steht;
4) Peroxide der allgemeinen Formel (VIII) 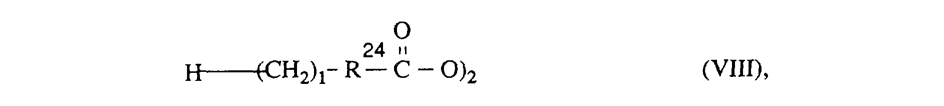 in welcher
   - 1: die Zahlen 0 bis 6, vorzugsweise 0, 1, 2, 3 oder 4, insbesondere 0, 1 oder 2, bedeutet und
   - R⁴: Phenylen, Naphthylen, C₃-C₆-Alkylen oder C₃-C₆-Cycloalkylen bedeutet.
   - L: eine Linkergruppierung und
   - y: die Zahl 0 oder 1, bevorzugt 1, bedeuten.

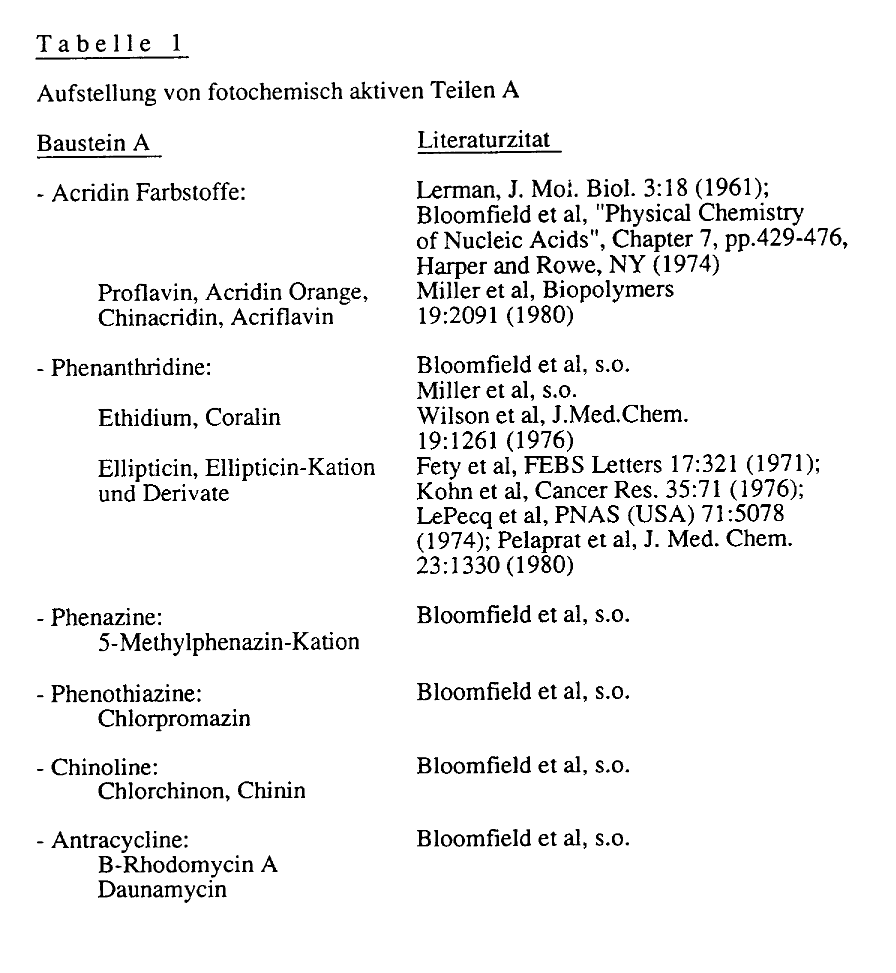

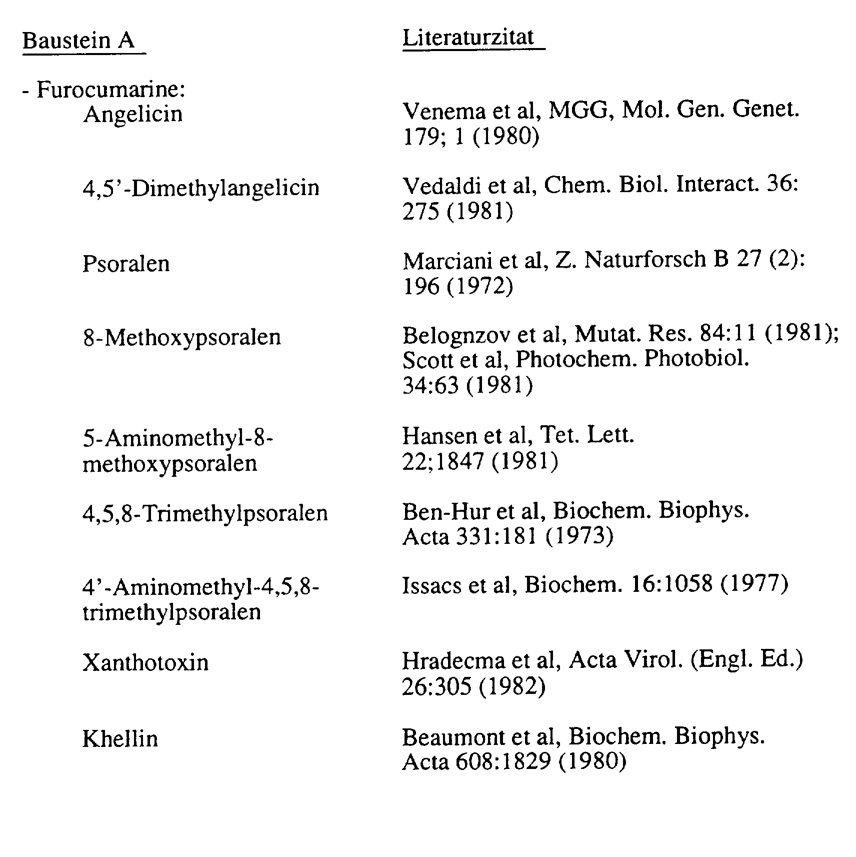

Furocumarine und Phenanthridine sind als fotochemisch reaktiver Teil A bevorzugt.

Besonders bevorzugt sind Angelicine der allgemeinen Formel (II) 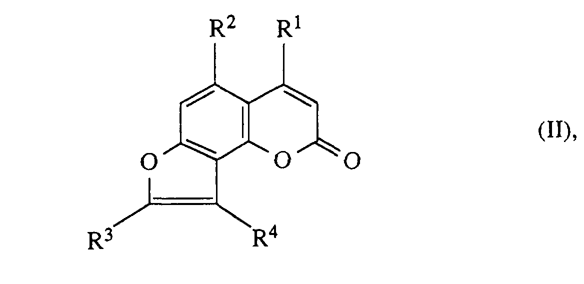 in welcher
- R¹, R und R³: unabhängig voneinander Wasserstoff oder C₁-C₄-Alkyl bedeuten und
- R⁴: Wasserstoff, C₁-C₄-Alkyl, durch Hydroxy, C₁-C₄-Alkoxy, Amino, Halogen und/oder den Rest 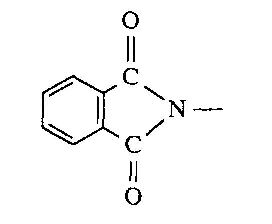 substituiertes C₁-C₄-Alkyl bedeutet,
und Psoralene der allgemeinen Formel (III) 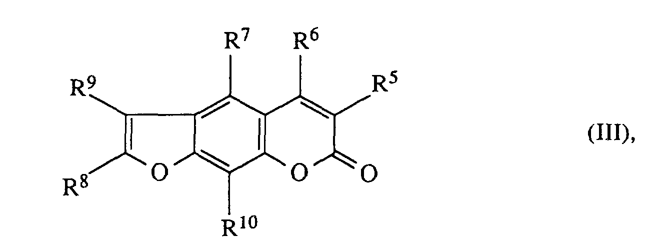 in welcher
- R⁵, R⁶, R⁷ und R⁸: unabhängig voneinander Wasserstoff oder C₁-C₄-Alkyl bedeuten,
- R⁹: Wasserstoff, C₁-C₄-Alkyl, durch Hydroxy, C₁-C₄-Alkoxy, Amino, Halogen und/oder 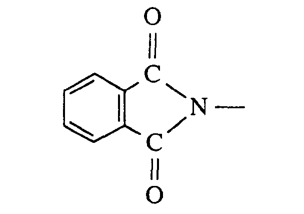 substituiertes C₁-C₄-Alkyl bedeutet und
- R¹⁰: Wasserstoff, Hydroxy, C₁-C₄-Alkyl, Carboxy, C₁-C₄-Alkoxycarbonyl oder C₁-C₄-Alkoxy bedeutet.

In den Formeln (II) und (III) stehen R¹, R, R³ und R⁵, R⁶, R⁷ und R⁸ unabhängig voneinander vorzugsweise für Wasserstoff oder Methyl.

In Formel (II) steht R⁴ vorzugsweise für Wasserstoff, Methyl oder Aminomethyl.

In Formel (III) stehen vorzugsweise R⁹ für Wasserstoff, Methyl, Hydroxymethyl oder Aminomethyl und R¹⁰ für Wasserstoff, Methyl, Hydroxy, Carboxy oder Methoxycarbonyl.

Besonders bevorzugt sind 4'-Aminomethyl-4,5'-dimethyl-angelicin der Formel (IIa) 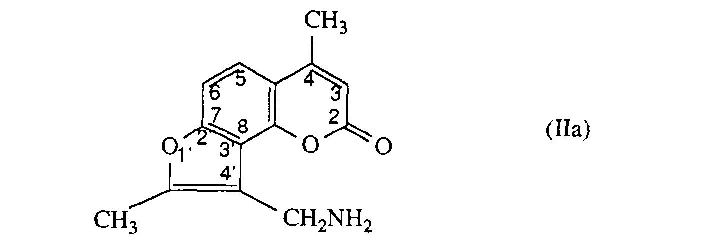 und die Verbindung der Formel (IIIa)

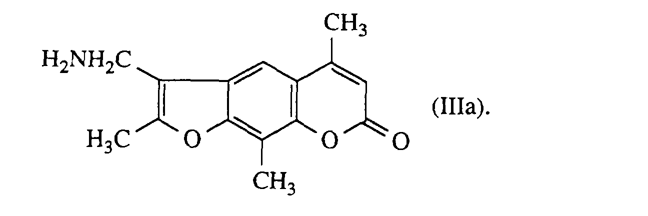

Beispielhaft seien die folgenden Angelicine der Formel (II) genannt:

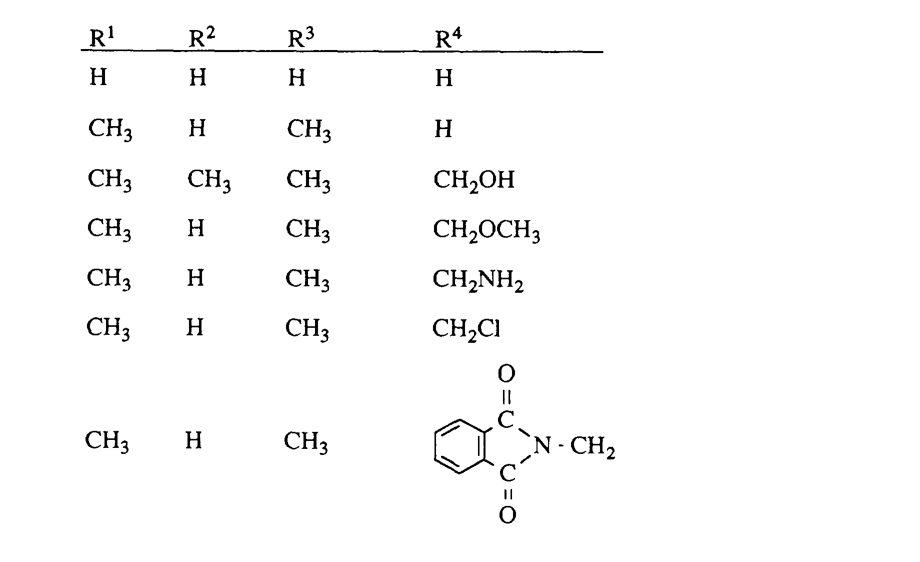

Als Linkergruppierung L kommen infrage:

Sulfonsäureester, Ester, Sulfonamid, Amid, Urethan, Thiourethan, Harnstoff, Thio-Harnstoff, Ether, Amin, Sulfid.

Bevorzugte Linkergruppierungen sind Amide und Harnstoffe sowie Ester und Urethane. Amide und Harnstoffe sind besonders bevorzugt.

Die Linkergruppierung L verknüpft den fotochemisch reaktiven Teil und den radikalbildenden Teil B kovalent miteinander.

Falls eine erhöhte Beweglichkeit der Bausteine A und/oder B erwünscht ist, kann durch L auch eine Abstandshalterfunktion ausgeübt werden, wobei L dann aus folgenden Untereinheiten der Formel (IV) bestehen kann:

L¹-R-L¹ (IV),

worin
- L¹: die bei L angegebenen Bedeutungen hat und
- R: für C₁-C₂₀-Alkylen, vorzugsweise C₃-C₁₅-Alkylen, besonders bevorzugt für C₅-C₁₀-Alkylen, für C₆-C₁₀-Arylen-C₂-C₁₀-Alkylen, vorzugsweise für Phenylen- bzw. Naphthylen-C₂-C₈-Alkylen, für (CH₂-CH₂-O)ₙ steht, worin
n 1 bis 20, vorzugsweise 3 bis 15 und besonders bevorzugt 5 bis 10, bedeutet.

Als radikalbildender Teil B kommen die bereits oben genannten Verbindungen der Formel (V), (VI), (VII) und (VIII) infrage.

Die unter 1) und 4) genannten Strukturen der Bausteine B sind bevorzugt.

Die Verbindungen der Formeln (V) bis (VIII) sind allgemein bekannt (vgl. beispielsweise US-PS 3 956 269, Houben-Weyl, Makromolekulare Stoffe, Teil 1, S.16-19).

Bevorzugte Azostrukturen der Formel (V) sind Verbindungen der Formel (Va) 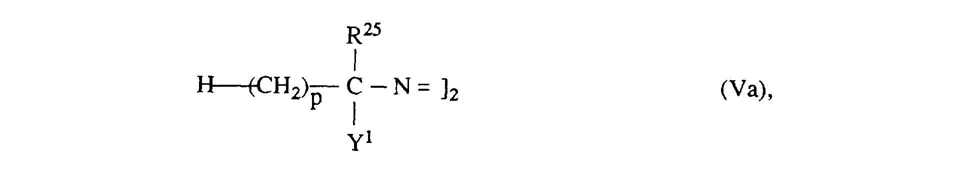 in welcher
- p: die Zahlen 1 bis 20, vorzugsweise 1 bis 15, insbesondere 2 bis 10, bedeutet,
- Y¹: für CN, N₃, COOR⁶ und
- R⁵ und R⁶: unabhängig voneinander C₁-C₆-Alkyl, insbesondere Methyl, Ethyl, n- oder iso-Propyl, oder C₃-C₆-Cycloalkyl, insbesondere Cyclopropyl, Cyclopentyl oder Cyclohexyl, bedeuten.

Eine besonders bevorzugte Struktur der unter 1) genannten Bausteine B hat die Formel (Vb) 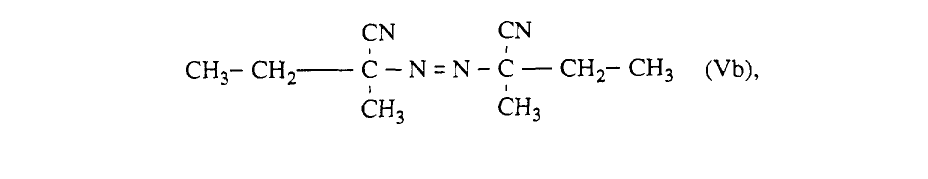 d.h., p bedeutet 2, R⁵ CH₃ und Y¹ CN.

Eine besonders bevorzugte Struktur der unter 4) genannten Bausteine B entspricht der Formel (VIII) mit l = O und R⁴ = Phenylen.

Die Strukturen der Formeln (V) bis (VIII), die den radikalbildenden Teil ausmachen, tragen 1 (y in Formel (I) = 0) oder 2 (y in Formel (I) = 2) reaktionsfähige Gruppen X¹ (vgl. Beschreibung der Formel (IX).

In den Azostrukturen der Formel (V) tragen die Reste R¹¹ und R¹ diese Gruppe (n). In den Strukturen der Formeln (Va), (Vb), (VI) und (VIII) sind die endständigen Wasserstoffatome durch diese Gruppe(n) ersetzt. Die Dinitrile der Formel (VII) tragen diese Gruppe(n) symmetrisch um die zentrale Bindung in R⁰, R¹ und/oder R³.

Im einzelnen seien beispielsweise die folgenden fotochemisch aktiven Initiatoren der Formel (I) aufgezeigt, wobei unter Angelicin A das 4'-Aminomethyl-4,5'-dimethyl-angelicin zu verstehen ist.

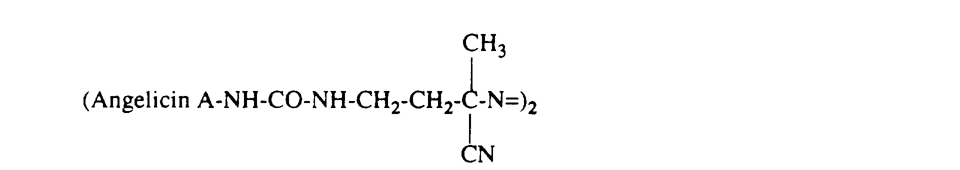

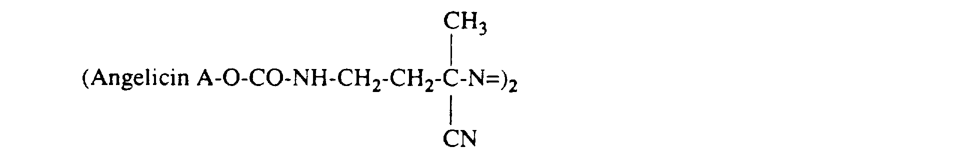

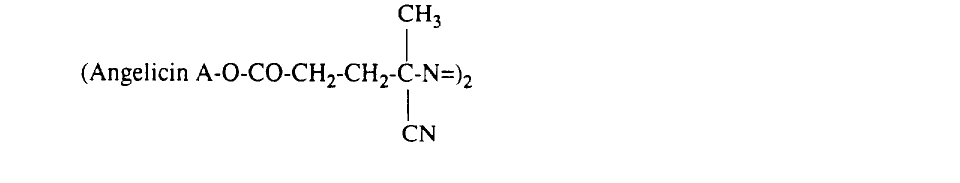

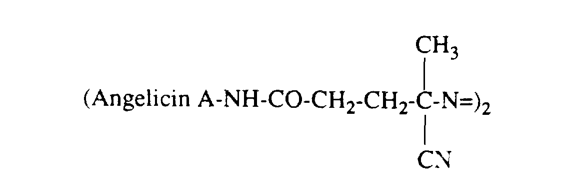

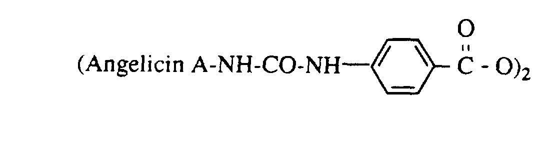

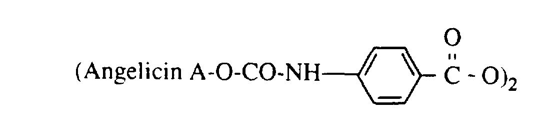

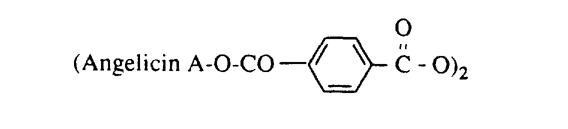

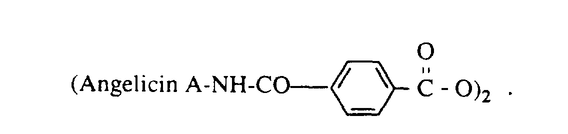

Es wurde weiterhin ein Verfahren zur Herstellung von fotochemisch aktiven Radikalketteninitiatoren der allgemeinen Formel (I) 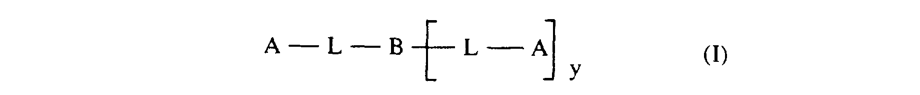 gefunden, dadurch gekennzeichnet, daß man radikalbildende Verbindungen der allgemeinen Formel (IX)

X¹-B(̵X¹)_{y} (IX),

wobei
- B: wie oben definiert ist und
- X¹: NCO, NCS, COCl, COOH, CO-O-NHS, OH, NH₂, SH, Cl, Br oder I sein kann und
- y: 0 oder 1, bevorzugt 1 ist,
mit 1 oder 2 Äquivalenten fotochemisch aktiven Substanzen A in gegenüber den unter X¹ genannten Gruppierungen chemisch inerten Lösungsmitteln, wie beispielsweise Chloraliphaten, Ketone, Nitrile, Sulfoxide, Sulfone u.ä., bei Temperaturen zwischen 0 und 40°C umsetzt.

Bei Verbindungen der allgemeinen Formel (IX),

X¹-B(̵X¹)_{y} (IX),

in denen
- X¹: COCl oder CONHSO₂Cl bedeutet,
ist dem Reaktionsgemisch zweckmäßigerweise ein Protonenfänger wie beispielsweise Pyridin oder Triethylamin zuzusetzen, wohingegen, wenn X = COOH, die Umsetzung in Gegenwart von Carbodiimiden, beispielsweise Dicyclohexylcarbodiimid, durchgeführt wird.

Als Verbindung der Formel X¹-B(̵X¹)_{y} werden in das erfindungsgemäße Verfahren bevorzugt Verbindungen, in denen X¹ = NCO und COCl bedeutet, eingesetzt.

Die Reaktion erfolgt bevorzugt zwischen 0 und 30°C, besonders bevorzugt zwischen 15 und 25°C und insbesondere bei ca. 20°C. Als Lösungsmittel werden bevorzugt CH₂Cl₂, Aceton oder Acetonitril eingesetzt.

Die Verbindungen der Formel (IX) sind allgemein bekannt oder lassen sich nach allgemein bekannten Verfahren herstellen (vgl. z.B. US-PS 4 155 937).

Die Linkergruppierung L wird gebildet durch die Umsetzung von X¹ aus der Formel X¹-B(̵X¹)_{y} mit der reaktiven Gruppe im fotochemisch reaktiven Baustein A, beispielsweise der Aminogruppe in Angelicin A.

Die Isolierung der fotochemisch aktiven Radikalkettenstarter erfolgt nach an sich bekannten Methoden, z.B. nach dem Abfiltrieren von gegebenenfalls gebildeten (ionischen) Nebenprodukten durch Abdampfen des Lösungsmittels im Hochvakuum, wenn niedrigsiedende Lösungsmittel verwendet werden, oder durch Ausfällung durch Zusatz eines geeigneten Fällungsrnittels, wobei das erfindungsgemäße Produkt in der Regel rein anfällt. In den Fällen, in denen die Nebenprodukte nicht flüchtig oder nicht durch Umlösen oder Filtrieren von den erfindungsgemäßen Verbindungen abtrennbar sind, erfolgt die Isolierung der erfindungsgemäßen Verbindungen durch an sich bekannte Methoden der Flüssigchromatographie, beispielsweise Säulenchromatographie oder präparative HPLC.

Die erfindungsgemäßen Verbindungen sind geeignet als Initiatoren für die radikalische Polymerisation von allen monomeren Verbindungen, die sich unter den an sich bekannten Bedingungen der Radikalkettenpolymerisation polymerisieren lassen. Die aus diesen Monomeren unter Initiierung der erfindungsgemäßen Verbindungen hergestellten Polymere besitzen durch den Initiatorzerfall gebildete fotochemisch aktive Endgruppen und lassen sich selektiv mit allen Substraten kovalent verbinden, die einer fotochemischen Reaktion mit der fotochemisch aktiven Endgruppe des Polymeren zugänglich sind.

Dadurch werden Verknüpfungsreaktionen mit Polymeren möglich, ohne daß eine Vernetzung zwischen den Verknüpfungsreaktanten oder Mehrfachverknüpfungen erfolgen können, da in der Regel nur eine, höchstens zwei Verknüpfungsgruppen pro Polymer zur Verfügung stehen. Erfindungsgemäße Verbindungen ermöglichen daher einen einfachen Zugang zu solch wertvollen monofunktionellen (Reaktiv-)Polymeren.

Als Monomerbausteine dieser Polymere kommen beispielsweise Acryl, Methacryl, Vinyl- oder Styryl-Reste oder Mischungen davon in Frage. Dabei kann es sich beispielsweise um deren Säure-, Ester-, Amid- oder Keton-Derivate handeln. Die Monomerbausteine können reaktive oder aktivierbare Gruppen enthalten, welche die kovalente Bindung beispielsweise zu einem Chelatbildner (z.B. 1,3-Diamino-2-hydroxypropan-N,N,N',N'-tetraessigsäure) ermöglichen. Derartige Gruppen können beispielsweise Säurehalogenid-, Imidester-, Benztriazolyl-, Isocyanato-, Isothiocyanato-, Oxiran- oder Diimid-Gruppen sein. Bevorzugte Monomerbausteine sind (Meth)Acrylsäurechlorid, (Meth)Acrylsäure-N-hydroxy-succinimidester, (Meth)Acrylsäure-N-hydroxy-phthalimidester, N-(Meth)-acryloylbenztriazol, 3- oder 4-Isothiocyanatophenyl-(meth)acrylat, 2-Isocyanatoethyl(meth)acrylat, Isocyanatoisopropenylbenzol, Isopropenyl-α,α-dimethylbenzylisocyanat, Vinyloxiran oder eine Kombination aus (Meth)Acrylsäure mit Carbodiimiden.

Das erfindungsgemäße Verfahren wird durch die nachfolgenden Beispiele näher erläutert.

Herstellung von fotochemisch aktiven Radikalkettenstartern der Formel (I):

### Beispiel 1

1 mmol 4'-Aminomethyl-4,5'-dimethylangelicin wird mit 1 mmol 3,3'-Dicyano-3,3'-azodibutylisocyanat in 20 ml trockenem CH₂Cl₂ bei Raumtemperatur bis zum Verschwinden der IR-Bande der NCO-Gruppe unter Reinststickstoff gerührt, das Lösungsmittel im Rotationsverdampfer bei Raumtemperatur abgedampft. Der Rückstand ergibt das laut ¹H-NMR reine erfindungsgemäße Produkt.

### Beispiel 2

p,p'-Bisisocyanatomethylbenzoylperoxid wird wie unter Beispiel 1 beschrieben mit 4'-Aminomethyl-4,5'-dimethylangelicin in CH₂Cl₂ umgesetzt, isoliert und charakterisiert.

### Beispiel 3

1 mmol 4,4'-Dicyano-4,4'-azodipentanoylchlorid wird mit 1 mmol 4'-Hydroxymethyl-4,5'-dimethylangelicin in 20 ml trockenem CH₂Cl₂ und 1,1 mmol Pyridin bis zum Verschwinden der IR-Bande der COCl-Gruppe unter Reinststickstoff gerührt. Nach beendeter Reaktion wird vom Pyridiniumhydrochlorid abfiltriert, das Filtrat im Vakuum bei Raumtemperatur einrotiert. Man erhält ein laut ¹H-NMR reines Produkt.

Herstellung von Polyacrylsäure mit fotochemisch aktiver Endgruppe:

### Beispiel 4

Unter Stickstoff werden 5 g Acrylsäure in 10 ml Dimethylsulfoxid und 10 ml entionisiertes Wasser gelöst, auf 65°C erhitzt und 50 mg des Radikalstarters aus Beispiel 1 zugegeben. Nach 2 h Rühren wird die hochviskose Lösung mit 20 ml entionisiertem Wasser verdünnt und über 15 h weiter gerührt. Das Rohpolymer wird in Aceton ausgefällt, abgesaugt, im Hochvakuum getrocknet. Die spezifische Viskosität beträgt 8,5 dl/g in 0,9 %iger NaCl-Lösung.

Verwendung:

### Beispiel 5

### Fotoreaktion von Beispiel 4 mit DNA

50 µl (0,4 µg DNA/µl) eines 1,7 kb-DNA-Fragments werden mit 2 µl einer Lösung der fotoreaktiven Polyacrylsäure (Beispiel 4) in Dimethylformamid (10,6 mg/ml) eine Stunde lang bei 365 nm belichtet.

Zur Kontrolle des Bindungsverhaltens wird das Reaktionsgemisch durch Agarosegelelektrophorese aufgetrennt (0,5 % bis 1 % Agarose, IX TBE-Puffer; 60 V; 2 h). (TBE = TRIS[Tris(hydroxymethyl)methylamin]-Borat-EDTA (Ethylendiamintetraessigsäure).

Die Reaktionsansätze, in denen eine Fotoreaktion mit DNA durchgeführt wurde, zeigen ein deutliches "Nachschleppen" der polymerbeladenen DNA verglichen zu unbelichteten Ansätzen reiner 1,7 kb DNA.

## Patentansprüche

1. Fotochemisch reaktive Initiatoren der allgemeinen Formel (I) 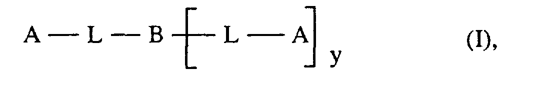 worin
A ausgewählt ist aus der Gruppe der Acridine, Furocumarine, Phenanthridine, Phenazine, Phenothiazine, Chinoline, Antracycline, Netropsin, Distamycin oder bis-Benzimidazole,
B ausgewählt ist aus folgenden Strukturen:
1) Azostrukturen der allgemeinen Formel (V)
R¹¹-N = N-R¹ (V),
worin
R¹¹ und R¹ C₁-C₂₀-Alkyl, C₃-C₁₀-Cycloalkyl, C₇-C₂₀-Aralkyl oder die Gruppe 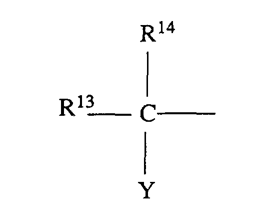 bedeuten, und
Y CN, N₃ oder 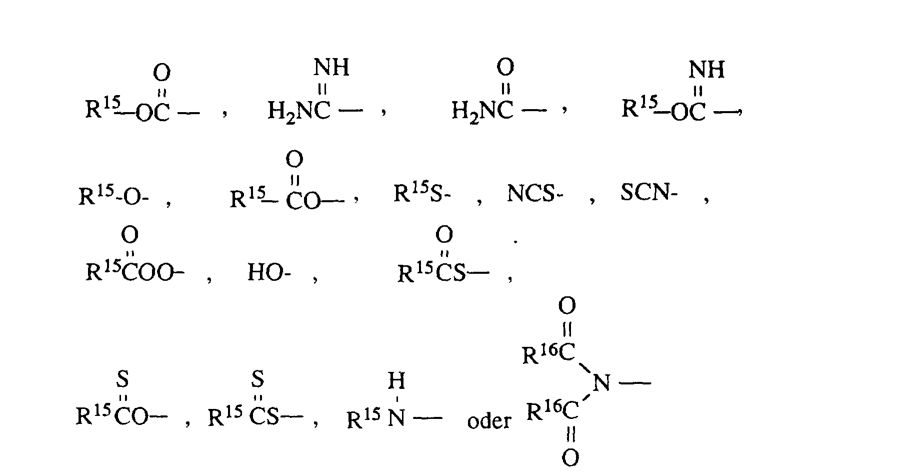 bedeudet,
R¹³, R¹⁴ und R¹⁵ unabhängig voneinander C₁-C₂₀-Alkyl, C₃-C₆-Cycloalkyl bedeuten oder wenn R¹³ und R¹⁴ verknüpft sind C₂-C₃₀-Alkylen bedeuten oder zusätzlich einer der Reste R¹³ oder R¹⁴, jedoch nicht beide gleichzeitig, Phenyl, Tolyl, Xylyl, Benzyl oder Phenethyl bedeutet,
R¹⁶ unabhängig C₁-C₆-Alkyl, C₃-C₆-Cycloalkyl oder C₆-C₁₂-Aryl bedeutet;
2) Tetraaryl/alkylethane der allgemeinen Formel (VI) 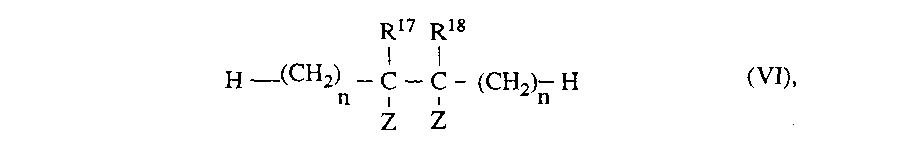 in welcher
Z für Hydroxy, C₁-C₆-Alkyl oder C₆-C₂₀-Aryl, insbesondere für Hydroxy, Methyl, Ethyl, n- oder iso-Propyl, Phenyl oder Naphthyl steht,
R¹⁷ und R¹⁸ unabhängig voneinander für C₁-C₆-Alkyl oder C₆-C₂₀-Aryl, insbesondere für Methyl, Ethyl, n- oder iso-Propyl, Phenyl oder Naphthyl stehen und
n für die Zahlen 1 bis 6, vorzugsweise 1, 2, 3, 4 oder 5, steht;
3) Dinitrile der Formel (VII) 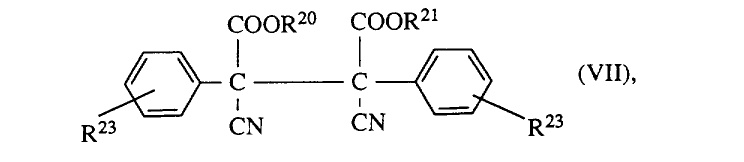 in welcher
R⁰, R¹ und R³ unabhängig voneinander für (CH₂)̵ₘH stehen,
worin
m für die Zahlen 1 bis 6, vorzugsweise 1, 2, 3, 4 oder 5 steht;
4) Peroxide der allgemeinen Formel (VIII) 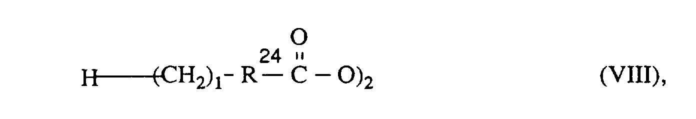 in welcher
1 die Zahlen 0 bis 6, vorzugsweise 0, 1, 2, 3 oder 4, insbesondere 0, 1 oder 2, bedeutet und
R⁴ Phenylen, Naphthylen, C₃-C₆-Alkylen oder C₃-C₆-Cycloalkylen bedeutet,
L eine Linkergruppierung und
y die Zahl 0 oder 1 bedeuten.

2. Fotochemisch reaktive Initiatoren der Formel (I) gemäß Anspruch 1, worin
L eine Sulfonsäureester-, Ester-, Sulfonamid-, Amid-, Urethan-, Thiourethan-, Harnstoff-, Thio-Harnstoff-, Ether-, Amin- oder Sulfid-Gruppe ist.

3. Fotochemisch reaktive Initiatoren der Formel (I) gemäß den Ansprüchen 1 und 2, worin
A ausgewählt ist aus der Gruppe der Furocumarine und Phenanthridine.

4. Fotochemisch reaktive Initiatoren der Formel (I) gemäß Anspruch 1, worin
A ausgewählt ist aus der Gruppe der Angelicine der allgemeinen Formel (II) 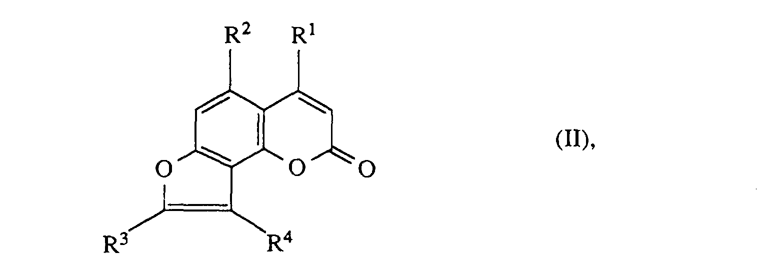 in welcher
R¹, R und R³ unabhängig voneinander Wasserstoff oder C₁-C₄-Alkyl bedeuten und
R⁴ Wasserstoff, C₁-C₄-Alkyl, durch Hydroxy, C₁-C₄-Alkoxy, Amino, Halogen und/oder den Rest 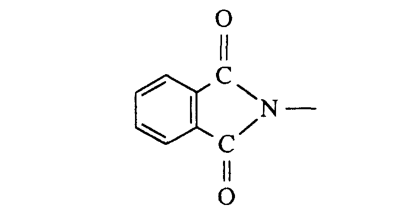 substituiertes C₁-C₄-Alkyl bedeutet,
und der Gruppe der Psoralene der allgemeinen Formel (III) 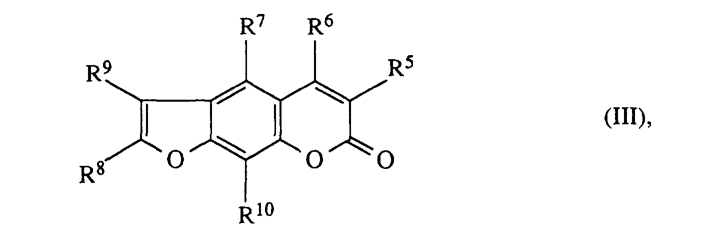 in welcher
R⁵, R⁶, R⁷ und R⁸ unabhängig voneinander Wasserstoff oder C₁-C₄-Alkyl bedeuten,
R⁹ Wasserstoff, C₁-C₄-Alkyl, durch Hydroxy, C₁-C₄-Alkoxy, Amino, Halogen und/oder 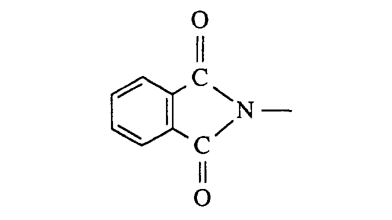 substituiertes C₁-C₄-Alkyl bedeutet und
R¹⁰ Wasserstoff, Hydroxy, C₁-C₄-Alkyl, Carboxy, C₁-C₄-Alkoxycarbonyl oder C₁-C₄-Alkoxy bedeutet.

5. Fotochemisch reaktive Initiatoren der Formel (I) gemäß den Ansprüchen 1 und 2, worin
L eine Amid-, Harnstoff-, Ester- oder Urethangruppierung ist.

6. Fotochemisch reaktive Initiatoren der Formel (I) gemäß Anspruch 1, worin
B aus der Struktur 1) und 4) ausgewählt ist.

7. Verfahren zur Herstellung von fotochemisch aktiven Initiatoren der allgemeinen Formel (I) 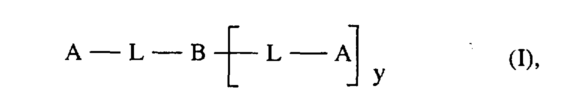 worin
A ausgewählt ist aus der Gruppe der Acridine, Furocumarine, Phenanthridine, Phenazine, Phenothiazine, Chinoline, Antracycline, Netropsin, Distamycin oder bis-Benzimidazole,
B ausgewählt ist aus folgenden Strukturen:
1) Azostrukturen der allgemeinen Formel (V)
R¹¹ - N = N - R¹ (V),
worin
R¹¹ und R¹ C₁-C₂₀-Alkyl, C₃-C₁₀-Cycloalkyl, C₇-C₂₀-Aralkyl oder die Gruppe 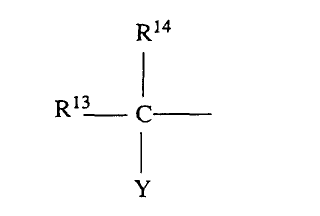 bedeuten, und
Y CN, N₃ oder 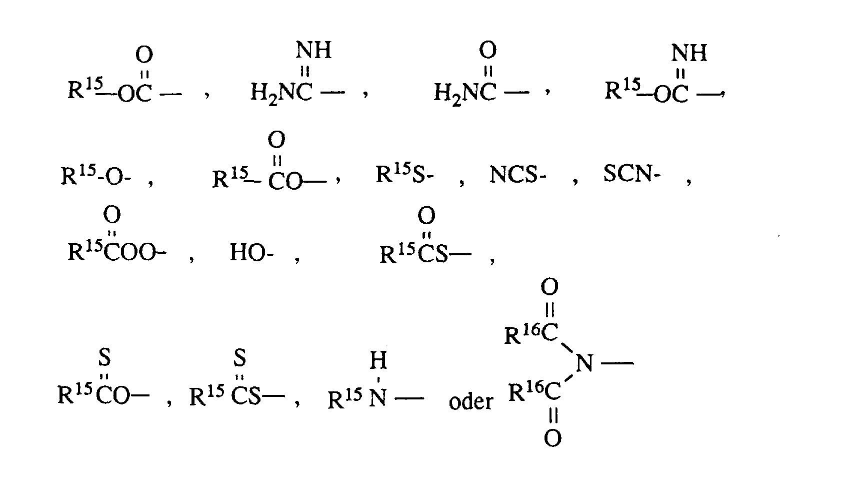 bedeudet,
R¹³, R¹⁴ und R¹⁵ unabhängig voneinander C₁-C₂₀-Alkyl, C₃-C₆-Cycloalkyl bedeuten oder wenn R¹³ und R¹⁴ verknüpft sind C₂-C₃₀-Alkylen bedeuten oder zusätzlich einer der Reste R¹³ oder R¹⁴, jedoch nicht beide gleichzeitig, Phenyl, Tolyl, Xylyl, Benzyl oder Phenethyl bedeutet,
R¹⁶ unabhängig C₁-C₆-Alkyl, C₃-C₆-Cycloalkyl oder C₆-C₁₂-Aryl bedeutet;
2) Tetraaryl/alkylethane der allgemeinen Formel (VI) 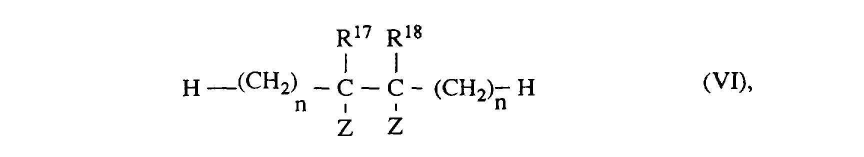 in welcher
Z für Hydroxy, C₁-C₆-Alkyl oder C₆-C₂₀-Aryl, insbesondere für Hydroxy, Methyl, Ethyl, n- oder iso-Propyl, Phenyl oder Naphthyl steht,
R¹⁷ und R¹⁸ unabhängig voneinander für C₁-C₆-Alkyl oder C₆-C₂₀-Aryl, insbesondere für Methyl, Ethyl, n- oder iso-Propyl, Phenyl oder Naphthyl stehen und
n für die Zahlen 1 bis 6, vorzugsweise 1, 2, 3, 4 oder 5, steht;
3) Dinitrile der Formel (VII) 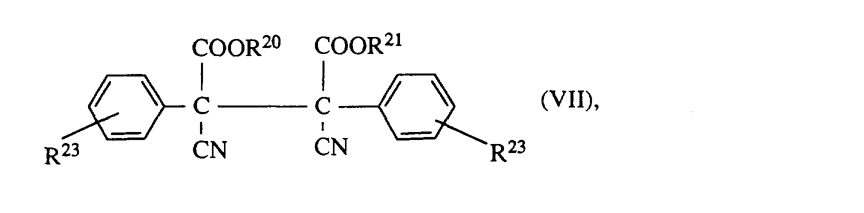 in welcher
R⁰, R¹ und R³ unabhängig voneinander für (CH₂)̵ₘH stehen,
worin
m für die Zahlen 1 bis 6, vorzugsweise 1, 2, 3, 4 oder 5 steht;
4) Peroxide der allgemeinen Formel (VIII) 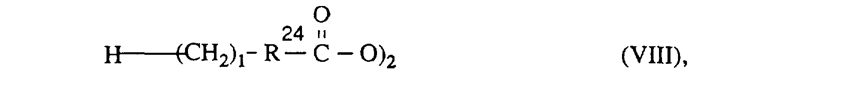 in welcher
l die Zahlen 0 bis 6, vorzugsweise 0, 1, 2, 3 oder 4, insbesondere 0, 1 oder 2, bedeutet und
R⁴ Phenylen, Naphthylen, C₃-C₆-Alkylen oder C₃-C₆-Cycloalkylen bedeutet,
L eine Linkergruppierung und y die Zahl 0 oder 1 bedeuten,
wobei man radikalbildende Verbindungen der allgemeinen Formel (IX)
X¹-B(̵X¹)_{y} (IX),
worin
X¹ NCO, NCS, COCI, COOH, CO-O-NHS, OH, NH₂, SH, Cl, Br oder I bedeutet,
mit 1 oder 2 Äquivalenten von fotochemisch aktiven Substanzen A umsetzt.

8. Verwendung der fotochemisch aktiven Initiatoren der Formel (I) gemäß Anspruch 1 und 7 für die radikalische Polymerisation.

## Claims

1. Photochemically reactive initiators of the general formula (I) 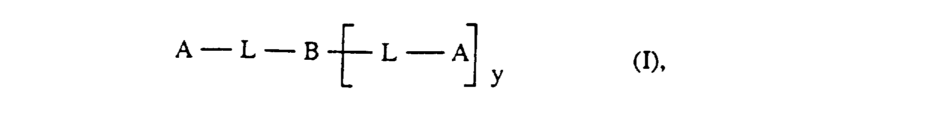 where
A is selected from the group comprising acridines, furocoumarins, phenanthridines, phenazines, phenothiazines, quinolines, anthracyclines, netropsin, distamycin or bis-benzimidazoles,
B is selected from the following structures:
1) azo structures of the general formula (V)
R¹¹ - N = N - R¹ (V),
where
R¹¹ and R¹ represent C₁₋₂₀ alkyl, C₃₋₁₀ cycloalkyl, C₇₋₂₀ aralkyl or the group 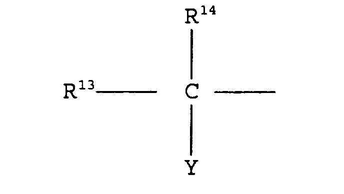 and
Y represents CN, N₃ or 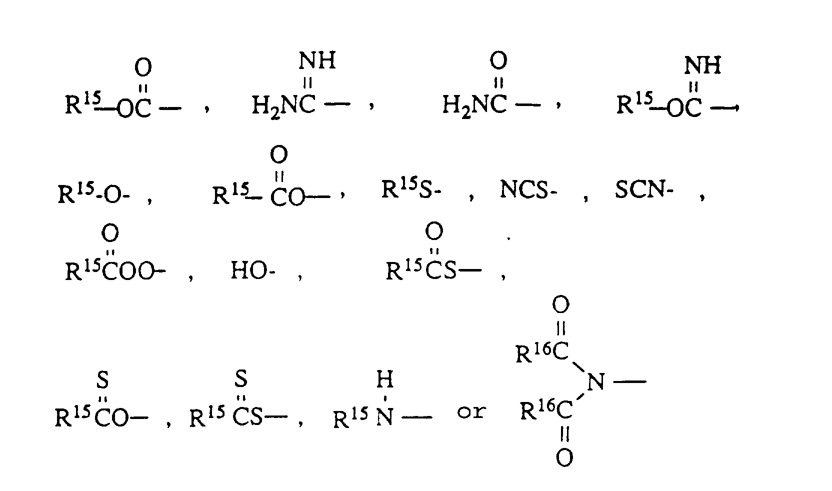
R¹³, R¹⁴ and R¹⁵ independently of one another represent C₁₋₂₀ alkyl, C₃₋₆ cycloalkyl or, if R¹³ and R¹⁴ are linked, represent C₂₋₃₀ alkylene or, in addition, one of the residues R¹³ or R¹⁴, but not both simultaneously, represents phenyl, tolyl, xylyl, benzyl or phenethyl,
R¹⁶ independently represents C₁₋₆ alkyl, C₃₋₆ cycloalkyl or C₆₋₁₂ aryl;
2) tetraaryl/alkyl ethanes of the general formula (VI) 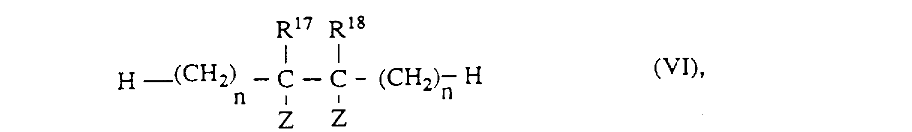 in which
Z stands for hydroxy, C₁₋₆ alkyl or C₆₋₂₀ aryl, in particular hydroxy, methyl, ethyl, n- or isopropyl, phenyl or naphthyl,
R¹⁷ and R¹⁸ independently of one another stand for C₁₋₆ alkyl or C₆₋₂₀ aryl, in particular methyl, ethyl, n- or isopropyl, phenyl or naphthyl and
n stands for a number in the range 1 to 6, preferably 1, 2, 3, 4 or 5;
3) Dinitriles of the formula (VII) 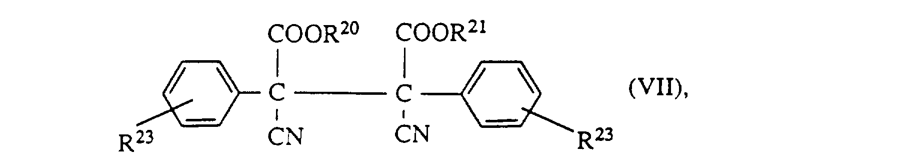 in which
R⁰, R¹and R³ independently of one another stand for (CH₂-)ₘ-H
where
m stands for a number in the range 1 to 6, preferably 1, 2, 3, 4 or 5;
4) Peroxides of the general formula (VIII) 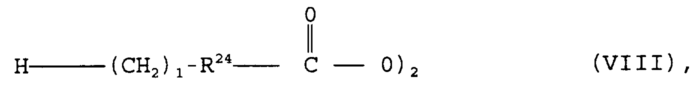 in which
l represents a number in the range 0 to 6, preferably 0, 1, 2, 3 or 4, and in particular 0, 1 or 2 and
R⁴ represents phenylene, naphthylene, C₃₋₆ alkylene or C₃₋₆ cycloalkylene,
L represents a linker group and
y represents the number 0 or 1.

2. Photochemically reactive initiators of the formula (I) according to Claim 1, in which
L is a sulphonate, ester, sulphonamide, amide, urethane, thiourethane, urea, thiourea, ether, amine or sulphide group.

3. Photochemically reactive initiators of the formula (I) according to Claims 1 and 2, in which
A is selected from the group comprising furocoumarins and phenanthridines.

4. Photochemically reactive initiators of the formula (I) according to Claim 1, in which
A is selected from the group comprising angelicines of the general formula (II) 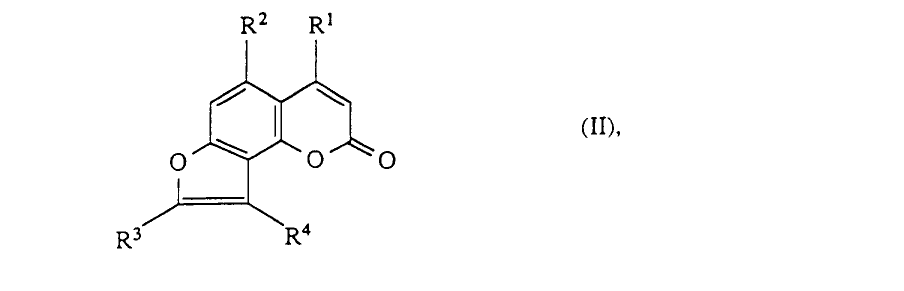 in which
R¹, R and R³ independently of one another represent hydrogen or C₁₋₄ alkyl and
R⁴ represents hydrogen, C₁₋₄ alkyl, C₁₋₄ alkyl substituted by hydroxy, C₁₋₄ alkoxy, amino, halogen and/or by the residue 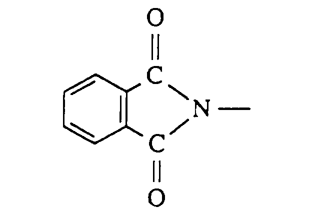
and from the group of psoralenes of the general formula (III) 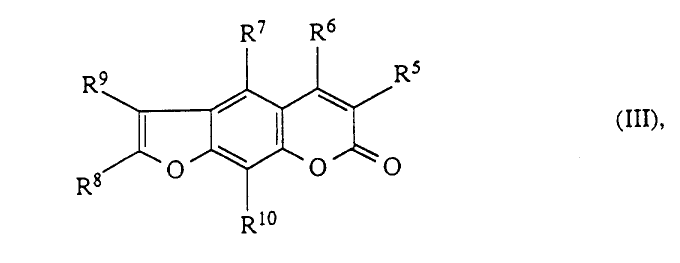 in which
R⁵, R⁶, R⁷ and R⁸ independently of one another represent hydrogen or C₁₋₄ alkyl,
R⁹ represents hydrogen, C₁₋₄ alkyl, C₁₋₄ alkyl substituted by hydroxy, C₁₋₄ alkoxy, amino, halogen and/or by 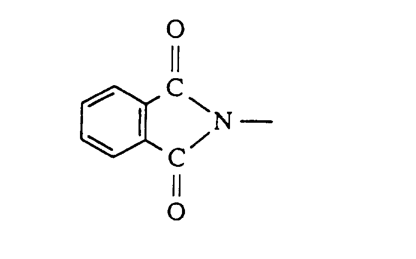 and
R¹⁰ represents hydrogen, hydroxy, C₁₋₄ alkyl, carboxy, C₁₋₄alkoxycarbonyl or C₁₋₄ alkoxy.

5. Photochemically reactive initiators of the formula (I) according to Claims 1 and 2, in which
L is an amide, urea, ester or urethane group.

6. Photochemically reactive initiators of the formula (I) according to Claim 1, in which
B is selected from structures 1) and 4).

7. Process for the production of photochemically active initiators of the general formula (I) 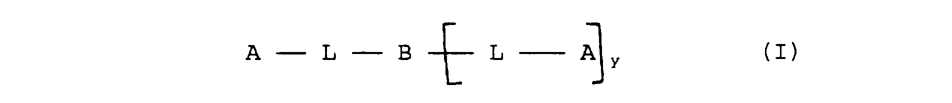 where
A is selected from the group comprising acridines, furocoumarins, phenanthridines, phenazines, phenothiazines, quinolines, anthracyclines, netropsin, distamycin or bis-benzimidazoles,
B is selected from the following structures:
1) azo structures of the general formula (V)
R¹¹ - N = N - R¹ (V),
where
R¹¹ and R¹ represent C₁₋₂₀ alkyl, C₃₋₁₀ cycloalkyl, C₇₋₂₀ aralkyl or the group 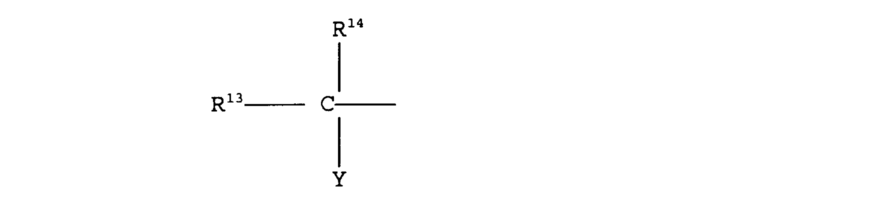 and
Y represents CN, N₃ or 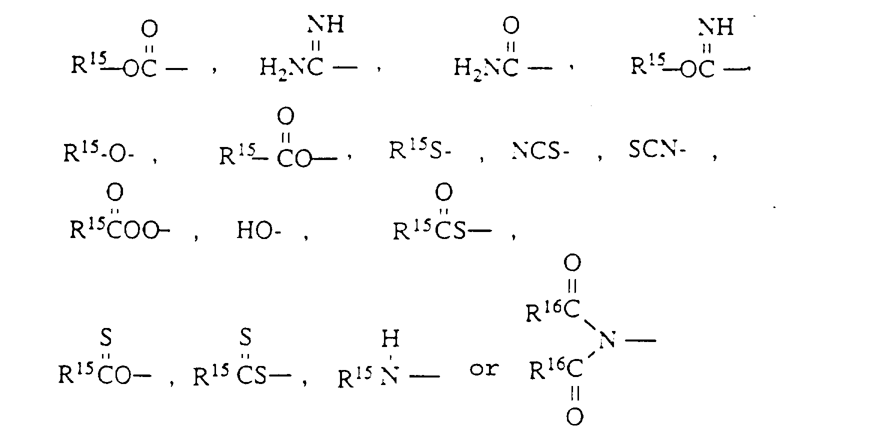
R¹³, R¹⁴ and R¹⁵ independently of one another represent C₁₋₂₀ alkyl, C₃₋₆ cycloalkyl or, if R¹³ and R¹⁴ are linked, represent C₂₋₃₀ alkylene or, in addition, one of the residues R¹³ or R¹⁴, but not both simultaneously, represents phenyl, tolyl, xylyl, benzyl or phenethyl,
R¹⁶ independently represents C₁₋₆ alkyl, C₃₋₆ cycloalkyl or C₆₋₁₂ aryl;
2) tetraaryl/alkyl ethanes of the general formula (VI) 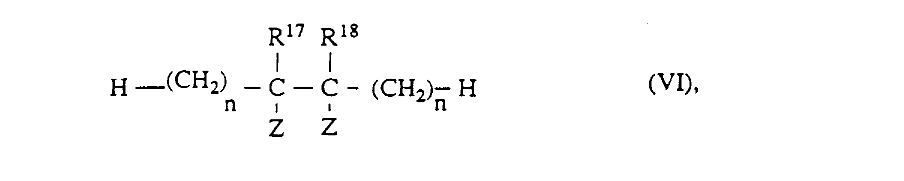 in which
Z stands for hydroxy, C₁₋₆ alkyl or C₆₋₂₀ aryl, in particular hydroxy, methyl, ethyl, n- or isopropyl, phenyl or naphthyl,
R¹⁷ and R¹⁸ independently of one another stand for C₁₋₆ alkyl or C₆₋₂₀ aryl, in particular methyl, ethyl, n- or isopropyl, phenyl or naphthyl and
n stands for a number in the range 1 to 6, preferably 1, 2, 3, 4 or 5;
3) Dinitriles of the formula (VII) 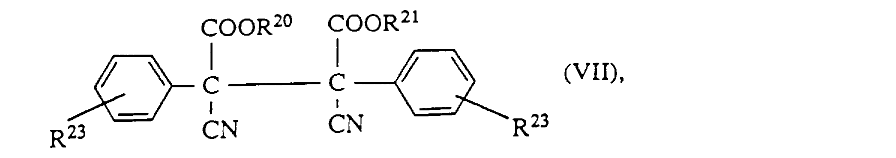 in which
R⁰, R¹ and R³ independently of one another stand for (CH₂)̵ₘH
where
m stands for a number in the range 1 to 6, preferably 1, 2, 3, 4 or 5;
4) Peroxides of the general formula (VIII) 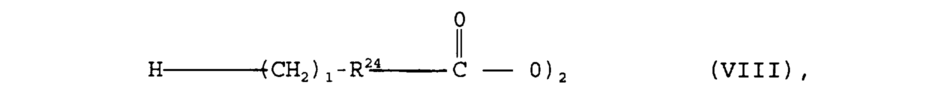 in which
l represents a number in the range 0 to 6, preferably 0, 1, 2, 3 or 4, and in particular 0, 1 or 2 and
R⁴ represents phenylene, naphthylene, C₃₋₆ alkylene or C₃₋₆ cycloalkylene,
L represents a linker group and
y represents the number 0 or 1,
wherein radical-forming compounds of the general formula (IX)
X¹ - B - (X¹)_{y} (IX),
in which
X¹ represents NCO, NCS, COCl, COOH, CO-O-NHS, OH, NH₂, SH, Cl, Br or I,
are reacted with 1 or 2 equivalents of photochemically active substances A.

8. Use of the photochemically active initiators of the formula (I) according to Claims 1 and 7 for radical polymerisation.

## Revendications

1. Inducteurs photochimiques réactifs de formule générale (I) 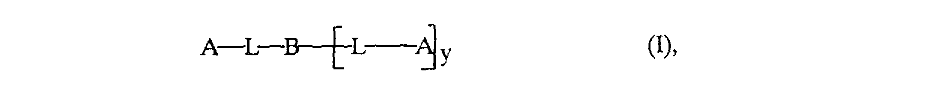 dans laquelle
A est choisi dans le groupe formé par les acridines, les furocoumarines, les phénanthridines, les phénazines, les phénothiazines, les quinoléines, les antracyclines, la nétropsine, la distamycine ou les bis-benzimidazoles,
B est choisi parmi les structures suivantes :
1) les structures azoïques de formule générale (V)
R¹¹-N = N-R¹ (V),
dans laquelle
R¹¹ et R¹ représentent chacun un groupe alkyle en C₁-C₂₀, cycloalkyle en C₃-C₁₀, aralkyle en C₇-C₂₀ ou le groupe 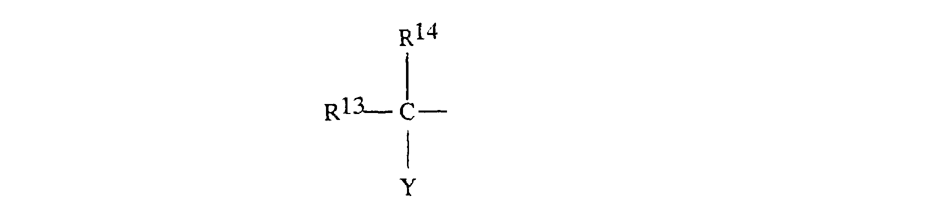 et
Y représente CN, N₃ ou 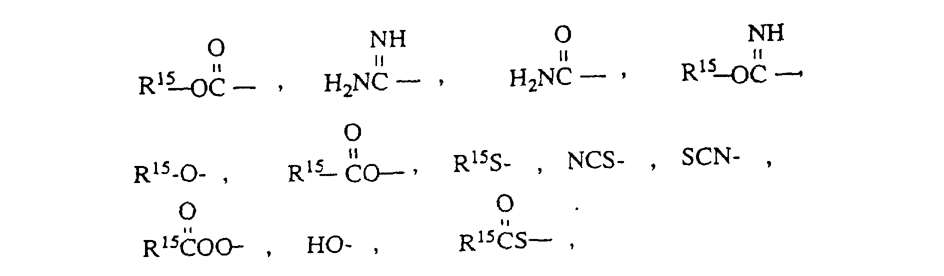 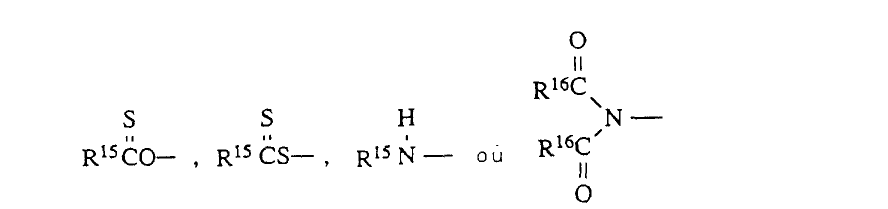
R¹³, R¹⁴ et R¹⁵ représentent chacun, indépendamment les uns des autres, un groupe alkyle en C₁-C₂₀, cycloalkyle en C₃-C₆, ou bien R¹³ et R¹⁴ sont reliés avec formation d'un groupe alkylène en C₂-C₃₀ ou bien encore l'un des symboles R¹³ et R¹⁴, mais non les deux, représente un groupe phényle, tolyle, xylyle, benzyle ou phénéthyle,
R¹⁶ représente, indépendamment, un groupe alkyle en C₁-C₆, cycloalkyle en C₃-C₆ ou aryle en C₆-C₁₂ ;
2) les tétraaryl/alkyléthanes de formule générale (VI) 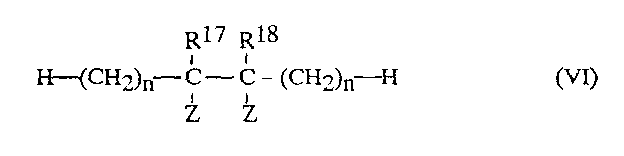 dans laquelle
Z représente un groupe hydroxy, alkyle en C₁-C₆ ou aryle en C₆-C₂₀, plus spécialement un groupe hydroxy, méthyle, éthyle, n- ou iso-propyle, phényle ou naphtyle,
R¹⁷ et R¹⁸ représentent chacun, indépendamment l'un de l'autre, un groupe alkyle en C₁-C₆ ou aryle en C₆-C₂₀, plus spécialement un groupe méthyle, éthyle, n- ou iso-propyle, phényle ou naphtyle et
n est un nombre allant de 1 à 6 et de préférence égal à 1, 2, 3, 4 ou 5 ;
3) les dinitriles de formule (VII) 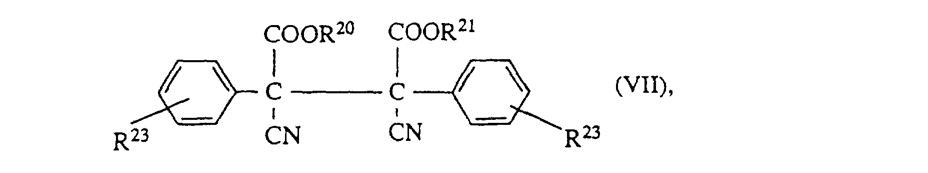 dans laquelle
R⁰, R¹ et R³ représentent chacun, indépendamment les uns des autres, un groupe (CH₂)̵ₘH,
dans lequel
m est un nombre allant de 1 à 6 et de préférence égal à 1, 2, 3 4 ou 5 ;
4) les peroxydes de formule générale (VIII) 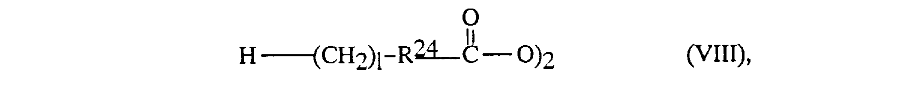 dans laquelle
l est un nombre allant de 0 à 6 et de préférence égal à 0, 1, 2, 3 ou 4 et plus spécialement à 0, 1 ou 2 et
R⁴ représente un groupe phénylène, naphtylène, alkylène en C₃-C₆ ou cycloalkylène en C₃-C₆,
L représente un groupement de liaison et
y est égal à 0 ou 1.

2. Inducteurs réactifs photochimiques de formule (I) selon revendication 1 dans laquelle
L représente un groupe ester sulfonique, ester, sulfonamide, amide, uréthane, thiouréthane, urée, thiourée, éther, amine ou sulfure.

3. Inducteurs réactifs photochimiques de formule (I) selon les revendications 1 et 2 dans laquelle
A est choisi dans le groupe des furocoumarines et des phénanthridines.

4. Inducteurs réactifs photochimiques de formule (I) selon revendication 1 dans laquelle
A est choisi dans le groupe des angélicines de formule générale (II) 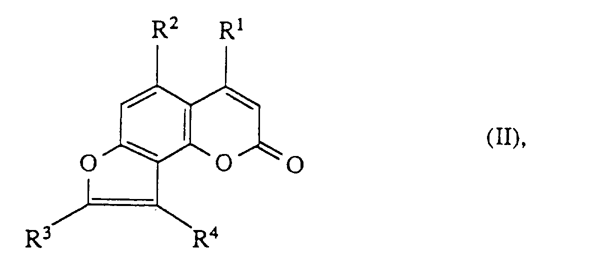 dans laquelle
R¹, R et R³ représentent chacun, indépendamment les uns des autres, l'hydrogène ou un groupe alkyle en C₁-C₄, et
R⁴ représente l'hydrogène, un groupe alkyle en C₁-C₄, un groupe alkyle en C₁-C₄ portant des substituants hydroxy, alcoxy en C₁-C₄, amino, halogéno et/ou le groupe 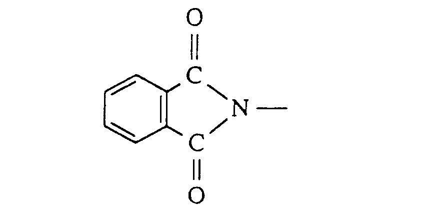
et le groupe des psoralènes de formule générale (III) 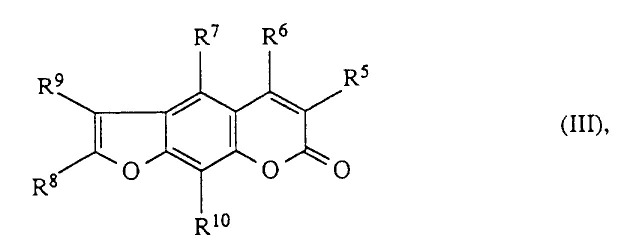 dans laquelle
R⁵, R⁶, R⁷ et R⁸ représentent chacun, indépendamment les uns des autres, l'hydrogène ou un groupe alkyle en C₁-C₄,
R⁹ représente l'hydrogène, un groupe alkyle en C₁-C₄, un groupe alkyle en C₁-C₄ portant des substituants hydroxy, alcoxy en C₁-C₄, amino, halogéno et/ou le groupe 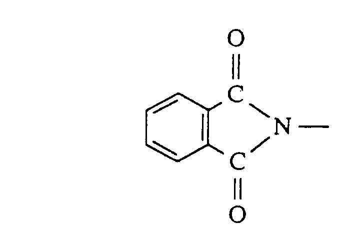 et
R¹⁰ représente l'hydrogène, un groupe hydroxy, alkyle en C₁-C₄, carboxy, (alcoxy en C₁-C₄)carbonyle ou alcoxy en C₁C₄.

5. Inducteurs réactifs photochimiques de formule (I) selon les revendications 1 et 2, dans laquelle
L représente un groupement amide, urée, ester ou uréthane.

6. Inducteurs réactifs photochimiques de formule (I) selon revendication 1 dans laquelle
B est choisi parmi les structures 1) et 4).

7. Procédé de préparation des inducteurs photochimiques actifs de formule générale (I) 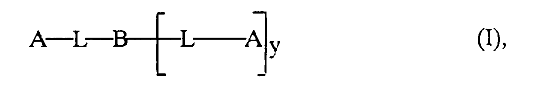 dans laquelle
A est choisi dans le groupe des acridines, des furocoumarines, des phénanthridines, des phénazines, des phénothiazines, des quinoléines, des antracyclines, de la nétropsine, de la distamycine ou des bis-benzimidazoles,
B est choisi parmi les structures suivantes :
1) les structures azoïques de formule générale (V)
R¹¹-N = N-R¹ (V),
dans laquelle
R¹¹ et R¹ représentent chacun un groupe alkyle en C₁-C₂₀, cycloalkyle en C₃-C₁₀, aralkyle en C₇-C₂₀ ou le groupe 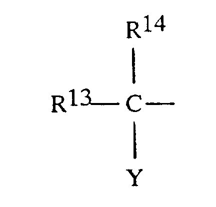 et
Y représente CN, N₃ ou 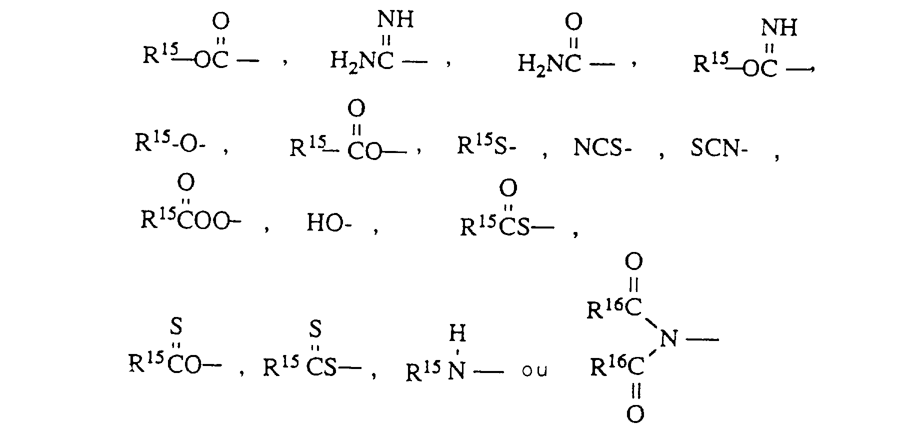
R¹³, R¹⁴ et R¹⁵ représentent chacun, indépendamment les uns des autres, un groupe alkyle en C₁-C₂₀, cycloalkyle en C₃-C₆, ou bien R¹³ et R¹⁴ sont reliés, formant un groupe alkylène en C₂-C₃₀ ou bien encore l'un des symboles R¹³ et R¹⁴, mais non les deux, représente un groupe phényle, tolyle, xylyle, benzyle ou phénéthyle,
R¹⁶ représente, indépendamment, un groupe alkyle en C₁-C₆, cycloalkyle en C₃-C₆ ou aryle en C₆-C₁₂ ;
2) les tétraaryl/alkyléthanes de formule générale (VI) 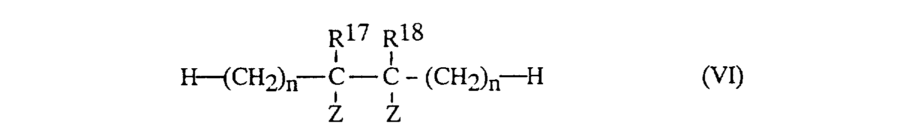 dans laquelle
Z représente un groupe hydroxy, alkyle en C₁-C₆ ou aryle en C₆-C₂₀, plus spécialement un groupe hydroxy, méthyle, éthyle, n- ou iso-propyle, phényle ou naphtyle,
R¹⁷ et R¹⁸ représentent chacun, indépendamment l'un de l'autre, un groupe alkyle en C₁-C₆ ou aryle en C₆-C₂₀, plus spécialement un groupe méthyle, éthyle, n- ou iso-propyle, phényle ou naphtyle et
n est un nombre allant de 1 à 6 et de préférence égal à 1, 2, 3, 4 ou 5 ;
3) les dinitriles de formule (VII) 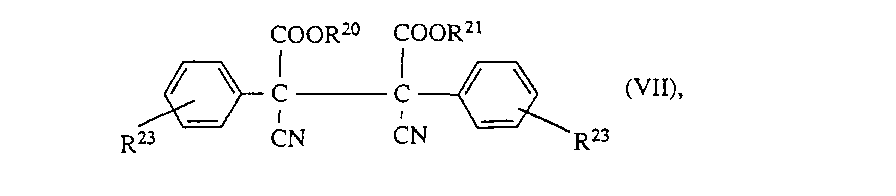 dans laquelle
R⁰, R¹ et R³ représentent chacun, indépendamment les uns des autres, un groupe (CH₂)̵ₘH,
dans lequel
m est un nombre allant de 1 à 6 et de préférence égal à 1, 2, 3 4 ou 5 ;
4) les peroxydes de formule générale (VIII) 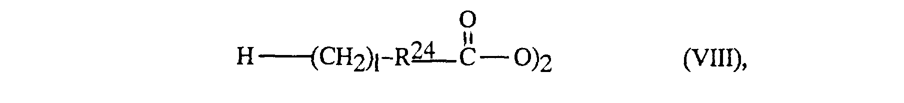 dans laquelle
l est un nombre allant de 0 à 6 et de préférence égal à 0, 1, 2, 3 ou 4 et plus spécialement à 0, 1 ou 2 et
R⁴ représente un groupe phénylène, naphtylène, alkylène en C₃-C₆ ou cycloalkylène en C₃-C₆,
L représente un groupement de liaison et y est égal à 0 ou 1,
dans lequel on fait réagir des composés radicalaires de formule générale (IX)
X¹-B(̵X¹)_{y} (IX)
dans laquelle
X¹ représente NCO, NCS, COCI, COOH, CO-O-NHS, OH, NH₂, SH, Cl, Br ou I et
avec un ou deux équivalents de substances actives photochimiques A.

8. Utilisation des inducteurs photochimiques actifs de formule (I) selon revendications 1 et 7 pour la polymérisation radicalaire.
